# FASCICULE DE BREVET EUROPEEN

(11) **EP 3 182 212 B1**
(45) Date de publication et mention de la délivrance du brevet: **11.03.2020**
(21) Numéro de dépôt: 16195713.9
(22) Date de dépôt: 26.10.2016
(51) Int. Cl.: B22D 19/04, B81C 3/00, C22C 45/00, C22C 45/10

(54) **PIÈCE COMPOSITE AVEC MOYENS ÉLASTIQUES SOUS CONTRAINTE**
VERBUNDWERKSTÜCK MIT UNTER SPANNUNG STEHENDEN ELASTISCHEN MITTELN
COMPOSITE PART WITH RESILIENT MEANS UNDER STRESS

(30) Priorité: 17.12.2015 EP 15200698
(43) Date de publication de la demande: 21.06.2017
(73) Titulaire: Nivarox-FAR S.A., 2400 Le Locle (CH)
(72) Inventeur: Dubois, Philippe, 2074 Marin (CH); Winkler, Yves, 3185 Schmitten (CH)
(74) Mandataire: Goulette, Ludivine

(56) Documents cités:
- EP-A2- 2 930 572
- WO-A2-2013/045706
- CH-A1- 706 645

## Description

### Domaine de l'invention

L'invention se rapporte à un assortiment horloger utilisant un alliage métallique amorphe et notamment un tel assortiment comportant une pièce horlogère dont le matériau ne comporte pas de domaine plastique utilisable, c'est-à-dire avec un domaine plastique très restreint.

### Arrière-plan de l'invention

Les assemblages actuels comportant une pièce à base de silicium sont généralement solidarisés par collage. Une telle opération nécessite une extrême finesse d'application ce qui la rend coûteuse. En alternative, selon CH 706 645 A1 une couche en un métal doux est interposée entre la pièce à base de silicium et l'axe de balancier qui est chassé dans un trou. WO 2013/045706 A2 décrit une virole en silicium comportant des zones élastiques constituées de bras courbés et destinée à être chassée sur un axe de balancier.

### Résumé de l'invention

Le but de la présente invention est de pallier tout ou partie les inconvénients cités précédemment en proposant un assortiment horloger n'utilisant pas de colle pour fixer notamment une pièce en matériau fragile sur un axe.

A cet effet, l'invention se rapporte à un procédé de fabrication d'une pièce composite comportant les étapes suivantes :
a) former un élément avec une ouverture dans laquelle s'étendent des moyens élastiques ;
b) passer un outil entre les moyens élastiques de l'élément afin de mettre sous contrainte les moyens élastiques ;
c) surmouler l'élément à l'aide d'un alliage métallique au moins partiellement amorphe afin d'emprisonner les moyens élastiques sous contrainte ;
d) retirer l'outil afin de former la pièce composite munie d'un passage de forme correspondante audit outil entre les moyens élastiques.

Le procédé permet donc d'obtenir une pièce composite parfaitement autocentrée. En effet, l'étape de surmoulage permet de garder les moyens élastiques à une contrainte de centrage sur l'outil qui garantit une très grande précision de positionnement.

De plus, le surmoulage permet de protéger l'élément contre les déformations plastiques ce qui autorise l'utilisation de matériau « fragile ». Ainsi, la pièce composite obtenue par le procédé peut être chassée, c'est-à-dire emmanchée, sur un arbre métallique avec très peu de risque de bris même si l'élément est, par exemple, à base de silicium. C'est en effet la partie à base d'alliage métallique au moins partiellement amorphe qui sera éventuellement déformée plastiquement.

Enfin, l'utilisation d'un alliage métallique au moins partiellement amorphe permet après la fabrication de la pièce composite ou après le chassage de la pièce composite, son démontage. En effet, un alliage métallique au moins partiellement amorphe peut être avantageusement réchauffé à une température prédéterminée qui le rend suffisamment mou pour ne plus opposer de résistance mécanique.

Conformément à d'autres variantes avantageuses de l'invention :
- les moyens élastiques forment au moins deux lames déformables raccordée de manière monobloc avec la paroi de l'ouverture de l'élément ;
- au moins une extrémité d'une desdites au moins deux lames déformables est reliée de manière monobloc à au moins une extrémité d'une autre desdites au moins deux lames déformables ;
- lesdites au moins deux lames déformables reliées entre elles forment une structure en forme de V, un polygone ou une structure en forme de Y ;
- lors de l'étape c), une ébauche en alliage métallique au moins partiellement amorphe est chauffée entre sa température de transition vitreuse (Tg) et sa température de cristallisation (Tx) afin de surmouler lesdits moyens élastiques ;
- lors de l'étape c), le surmoulage en alliage métallique au moins partiellement amorphe forme une partie en saillie de l'élément afin d'offrir une épaisseur de la pièce composite uniquement réalisée en alliage métallique au moins partiellement amorphe ;
- lors de l'étape c), un moule est rapporté sur l'élément pour délimiter la zone de l'élément pouvant être surmoulée avec l'alliage métallique au moins partiellement amorphe.

De plus, l'invention se rapporte à une pièce composite comportant un élément pourvu d'un volume en alliage métallique au moins partiellement amorphe et de moyens élastiques sous contrainte emprisonnés dans ledit volume, ladite pièce composite comportant un passage centré par rapport aux dits moyens élastiques sous contrainte.

Les moyens élastiques emprisonnés permettent d'obtenir un passage parfaitement autocentré. En effet, les moyens élastiques, ayant été surmoulés alors qu'ils étaient sous contrainte par un outil, permettent de garantir une très grande précision de positionnement.

De manière additionnelle, même si, accidentellement, l'élément se brisait au niveau d'un des moyens élastiques, par exemple, par un choc induit à la pièce d'horlogerie, la tenue serait quand même assurée par le surmoulage. Les parties de l'élément qui se seraient, éventuellement, rompues seraient en effet maintenues en place par le surmoulage, évitant ainsi la libération de celles-ci dans le mouvement de la pièce d'horlogerie.

Enfin, l'utilisation d'un alliage métallique au moins partiellement amorphe permet le démontage de la pièce composite. En effet, un alliage métallique au moins partiellement amorphe peut être avantageusement réchauffé à une température prédéterminée qui le rend suffisamment mou pour ne plus opposer de résistance mécanique.

Conformément à d'autres variantes avantageuses de l'invention :
- les moyens élastiques forment au moins deux lames déformables raccordée de manière monobloc avec la paroi de l'ouverture de l'élément ;
- au moins une extrémité d'une desdites au moins deux lames déformables est reliée de manière monobloc à au moins une extrémité d'une autre desdites au moins deux lames déformables ;
- lesdites au moins deux lames déformables reliées entre elles forment une structure en forme de V, un polygone ou une structure en forme de Y;
- le volume en alliage métallique au moins partiellement amorphe forme une partie en saillie de l'élément afin d'offrir une épaisseur de la pièce composite uniquement réalisée en alliage métallique au moins partiellement amorphe ;
- l'élément comporte du silicium monocristallin dopé ou non, du silicium polycristallin dopé ou non, de l'oxyde de silicium, du quartz, de la silice, du corindon monocristallin, du corindon polycristallin, de l'alumine, du rubis, du nitrure de silicium ou du carbure de silicium ;
- l'élément comporte au moins un revêtement partiel d'oxyde de silicium, de nitrure de silicium, de carbure de silicium ou d'un allotrope du carbone ;
- le volume en alliage métallique au moins partiellement amorphe est formé à base magnésium, à base titane, à base zirconium, à base fer, à base cobalt, à base or, à base palladium ou à base platine ;
- le volume en alliage métallique au moins partiellement amorphe est formé par un alliage du type ZrTiCuNiBe, PdCuNiP ou PtCuNiP.

Enfin, l'invention se rapporte à un assortiment comportant un arbre chassé dans le passage d'une pièce composite selon l'une des variantes précédentes.

On comprend donc que la pièce composite comporte une force de maintien sur l'arbre qui est améliorée. Ainsi, l'axe chassé dans la pièce composite présente une rigidité bien supérieure à celle de simples structures élastiques du même élément sans surmoulage. De plus, la tenue en couple est fonction de la pression exercée par la matière déformée du trou sur l'axe. On comprend donc que cette pression est nettement plus élevée dans le cas de la pièce composite.

De plus, le volume en alliage métallique au moins partiellement amorphe permet de protéger l'élément contre les déformations plastiques ce qui autorise l'utilisation de matériau « fragile ». Ainsi, la pièce composite peut être chassée, c'est-à-dire emmanchée, sur un arbre métallique avec très peu de risque de bris même si l'élément est, par exemple, à base de silicium. C'est en effet le volume en alliage métallique au moins partiellement amorphe qui sera éventuellement déformée plastiquement.

Enfin, l'utilisation d'un alliage métallique au moins partiellement amorphe permet le démontage de l'assortiment. En effet, un alliage métallique au moins partiellement amorphe peut être avantageusement réchauffé à une température prédéterminée qui le rend suffisamment mou pour ne plus opposer de résistance mécanique.

Conformément à d'autres variantes avantageuses de l'invention :
- l'arbre est agencé pour se chasser uniquement contre le volume en alliage métallique au moins partiellement amorphe de la pièce composite ;
- le passage est agencé pour l'arbre se chasse uniquement contre le volume en alliage métallique au moins partiellement amorphe de la pièce composite ;
- la pièce composite est bloquée contre une portée de l'arbre ;
- l'assortiment forme tout ou partie d'un rouage, d'un système d'échappement ou d'un résonateur d'une pièce d'horlogerie.

### Description sommaire des dessins

D'autres particularités et avantages ressortiront clairement de la description qui en est faite ci-après, à titre indicatif et nullement limitatif, en référence aux dessins annexés, dans lesquels :
- la figure 1 est une vue de dessus d'une pièce composite selon l'invention ;
- la figure 2 est une vue de dessous d'une pièce composite selon l'invention ;
- la figure 3 est une vue en coupe d'une pièce composite selon l'invention ;
- les figures 4 à 6 sont des représentations d'alternatives d'éléments selon l'invention ;

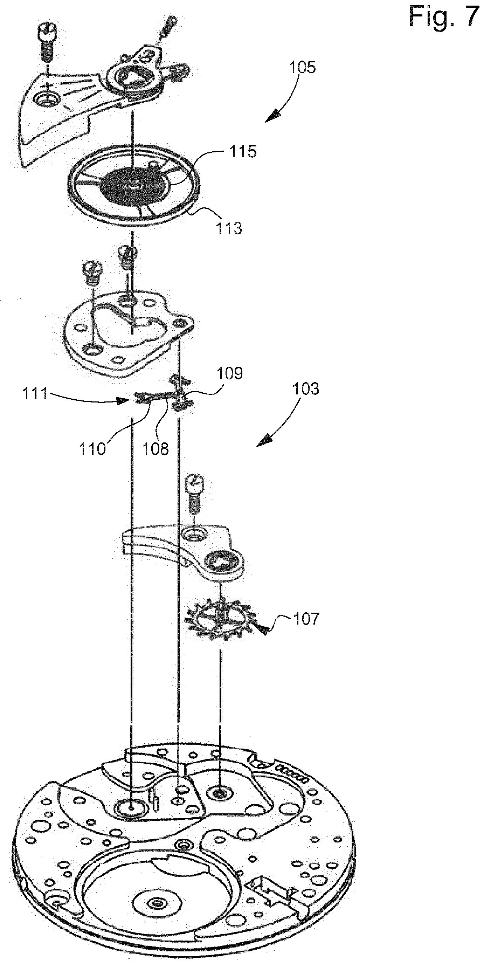

- la figure 7 est une vue en éclatée d'un mouvement horloger selon l'invention ;
- la figure 8 est une représentation d'un rouage selon l'invention ;
- la figure 9 est une représentation d'un assortiment selon un premier mode de réalisation de l'invention ;
- les figures 10 à 12 sont des représentations d'autres modes de réalisation d'assortiments selon l'invention.

### Description détaillée des modes de réalisation préférés

L'invention se rapporte à une pièce composite et à un assortiment comportant une telle pièce composite pour une pièce d'horlogerie utilisant un alliage métallique amorphe. Plus précisément, la pièce composite comporte un élément dont le matériau peut ne pas comporter de domaine plastique utilisable, c'est-à-dire avec un domaine plastique très restreint.

Un tel matériau peut être de manière nullement limitative du silicium monocristallin dopé ou non, du silicium polycristallin dopé ou non, de l'oxyde de silicium, du quartz, de la silice, du corindon monocristallin, du corindon polycristallin, de l'alumine, du rubis, du nitrure de silicium ou du carbure de silicium. Ce matériau pouvant comporter au moins un revêtement partiel d'oxyde de silicium, de nitrure de silicium, de carbure de silicium ou d'un allotrope du carbone. Bien entendu, d'autres types de matériaux tels que d'autres céramiques peuvent envisagés tout comme d'autres types de revêtements.

Comme expliqué ci-dessus, les assemblages actuels comportent de plus en plus de pièces à base de silicium et sont généralement solidarisés par collage. C'est pourquoi, la pièce composite selon l'invention a été développée pour former tout ou partie d'un rouage 101, d'un système d'échappement 103 ou d'un résonateur 105. Toutefois, d'autres applications sont possibles et pas seulement dans le domaine de l'horlogerie sans sortir du cadre de la présente invention.

A titre d'exemples nullement limitatifs, la pièce composite peut ainsi former une roue 102, un pignon 104, une masse oscillante, un ressort (tel par exemple qu'un ressort de barillet), une roue d'échappement 107, une baguette 108 d'ancre 109, un dard 110 d'ancre 109, une fourchette 111 d'ancre 109, un balancier 113, un plateau (tel par exemple qu'un double plateau tenant une cheville) ou un spiral 115. Dans les figures, une virole d'un spiral horloger sera utilisée afin de pouvoir mieux comparer les alternatives et les modes de réalisation décrits.

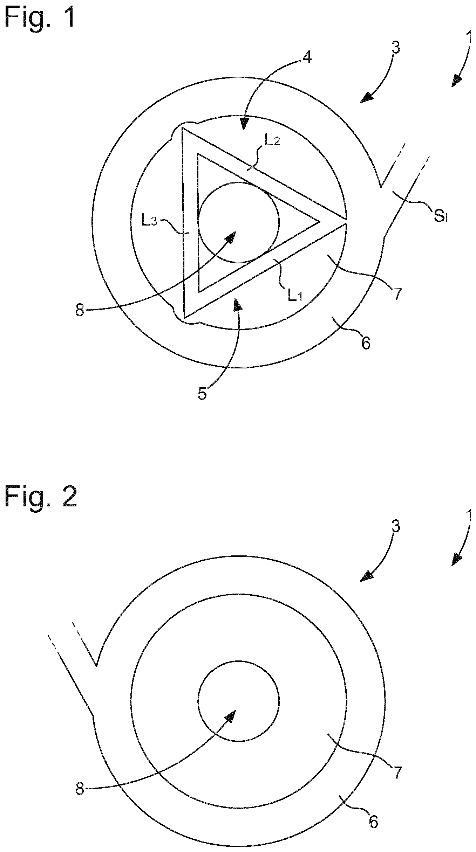

Comme illustré aux figures 1 à 3, l'invention se rapporte à une pièce composite 1 comportant un élément 3 avec une ouverture 4. Comme expliqué ci-dessus, l'élément 3 peut avantageusement être formé par un matériau qui ne comporte pas de domaine plastique utilisable, c'est-à-dire avec un domaine plastique très restreint, comme par exemple à base de silicium.

Selon l'invention, dans l'ouverture 4 s'étendent des moyens élastiques 5, c'est-à-dire des structures élastiques aptes à se déformer élastiquement, qui sont préférentiellement monoblocs avec la paroi entourant l'ouverture 4 de la pièce composite 3. Dans l'exemple visible aux figures 1 à 3, l'élément 3 comporte ainsi une virole 6 sensiblement annulaire monobloc avec une spire interne S_{I} d'un spiral et dont l'ouverture 4 comporte des moyens élastiques 5.

Préférentiellement, les moyens élastiques selon l'invention forment au moins deux lames déformables raccordée de manière monobloc avec la paroi de l'ouverture de l'élément. Ainsi, dans l'exemple de la figure 1, les moyens élastiques 5 comportent trois lames L₁, L₂, L₃ déformables reliées entre elles en formant un triangle monobloc et solidaire de la paroi interne de la virole 6 au niveau de la jonction entre les lames L₁ et L₂.

Avantageusement selon l'invention comme expliqué ci-dessous, moyens élastiques 5 sous contrainte, c'est-à-dire déformés élastiquement, sont emprisonnés dans un volume 7 en alliage métallique au moins partiellement amorphe. On s'aperçoit également qu'un passage 8, c'est-à-dire une zone sans matière est présente dans la pièce composite 1. Avantageusement selon l'invention, le passage 8 est centré par rapport aux moyens élastiques 5 grâce à leur état sous contrainte comme cela sera mieux expliqué ci-dessous.

Dans l'exemple des figures 1 à 3, on peut également voir que le volume 7 en alliage métallique au moins partiellement amorphe forme une partie 9 en saillie de l'élément 3 afin d'offrir une épaisseur E de la pièce composite 1 uniquement réalisée en alliage métallique au moins partiellement amorphe.

Préférentiellement selon l'invention, le volume 7 en alliage métallique au moins partiellement amorphe est formé à base magnésium, à base titane, à base zirconium, à base fer, à base cobalt, à base or, à base palladium ou à base platine comme par exemple du type ZrTiCuNiBe, PdCuNiP ou PtCuNiP. Les termes au moins partiellement amorphe signifient que l'alliage métallique peut être partiellement ou totalement sous une phase amorphe. Préférentiellement au moins 20%, de manière encore plus préférée au moins 50% et selon le plus préféré au moins 80%, de l'alliage métallique est sous phase amorphe.

On comprend donc que les moyens élastiques 5 emprisonnés permettent d'obtenir un passage 8 parfaitement autocentré. En effet, les moyens élastiques 5 ayant été emprisonnés alors qu'ils étaient sous contrainte permettent de garantir une très grande précision de positionnement.

De plus, l'utilisation d'un alliage métallique au moins partiellement amorphe permet le démontage de la pièce composite 1. En effet, le volume 7 en alliage métallique au moins partiellement amorphe peut être avantageusement réchauffé à une température prédéterminée qui le rend suffisamment mou pour ne plus opposer de résistance mécanique, c'est-à-dire est capable de fluer.

En effet, la viscosité d'un alliage métallique au moins partiellement amorphe tel que cité ci-dessus, lorsqu'il est chauffé entre sa température de transition vitreuse et sa température de cristallisation, peut être diminuée au point de fluer.

Enfin, le chassage dans la pièce composite 1 présente une rigidité bien supérieure à celle de simples structures élastiques 5 du même élément 3 sans surmoulage. De plus, la tenue en couple est fonction de la pression exercée par la matière déformée du trou. On comprend donc que cette pression est nettement plus élevée dans le cas de la pièce composite 1 selon l'invention.

Bien entendu, d'autres alternatives aux moyens élastiques 5 et, incidemment à l'élément 3, sont possibles. Ainsi, de manière générale, au moins une extrémité d'une desdites au moins deux lames déformables est reliée de manière monobloc à au moins une extrémité d'une autre desdites au moins deux lames déformables afin d'offrir un centrage de la pièce par déformation des moyens élastiques.

A titre d'exemple, on pourrait ainsi avoir un passage formé entre la paroi interne de la virole et des moyens élastiques comportant uniquement deux lames déformables. On comprend alors que lesdites au moins deux lames déformables reliées entre elles pourraient former une structure en forme de V.

Toutefois, de manière préférée, lesdites au moins deux lames déformables reliées entre elles forment un polygone, c'est-à-dire comportent 3 lames ou plus reliées entre elles, afin que le passage soit totalement entouré par les moyens élastiques.

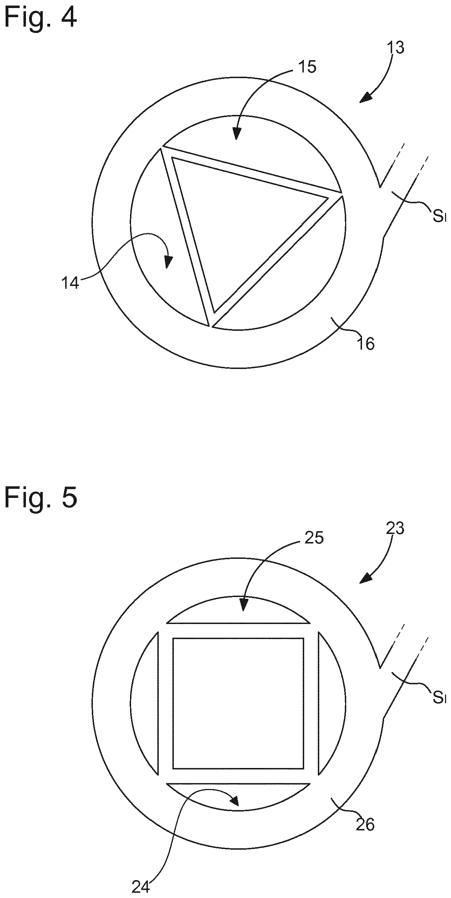

Une première alternative d'élément 13 est présentée à la figure 4. Ainsi, comparativement à la figure 1, on s'aperçoit que les moyens élastiques 15 sont toujours montés dans l'ouverture 14 d'une virole 16 et comportent trois lames formant un triangle, c'est-à-dire trois structures en forme de V imbriquées. Toutefois, on remarque que, dans cette première alternative, chaque sommet du triangle, ou chaque base de la structure en V, est relié de manière monobloc avec la paroi interne de la virole 16.

Une deuxième alternative d'élément 23 est présentée à la figure 5. Ainsi, comparativement à la figure 1, on s'aperçoit que les moyens élastiques 25 sont toujours montés dans l'ouverture 24 d'une virole 26. Toutefois, on remarque que, dans cette deuxième alternative, les moyens élastiques 25 comportent quatre lames formant un carré, c'est-à-dire quatre structures en forme de V imbriquées. De plus, chaque sommet du carré, ou chaque base de la structure en V, est relié de manière monobloc avec la paroi interne de la virole 26.

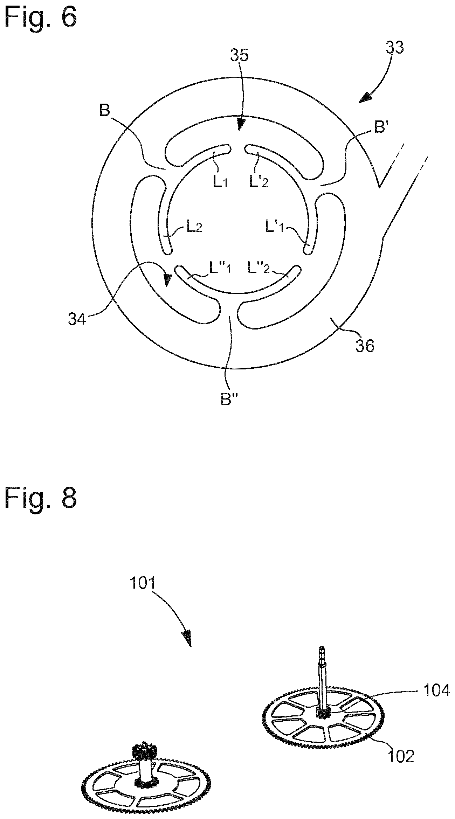

Il est également possible de changer les structures en forme de V par une structure en forme de Y, c'est-à-dire une structure en V reliée de manière monobloc par l'intermédiaire d'une base. A titre d'exemple nullement limitatif, une troisième alternative d'élément 33 est ainsi présentée à la figure 6. Ainsi, comparativement à la figure 1, on s'aperçoit que les moyens élastiques 35 sont toujours montés dans l'ouverture 34 d'une virole 36. Toutefois, on remarque que, dans cette troisième alternative, les moyens élastiques 35 comportent trois structures en forme de Y comportant chacune deux lames L₁, L₂, L'₁, L'₂, et L"₁, L"₂, déformables reliées de manière monobloc avec la paroi interne de la virole 36 par l'intermédiaire d'une base B, B', B".

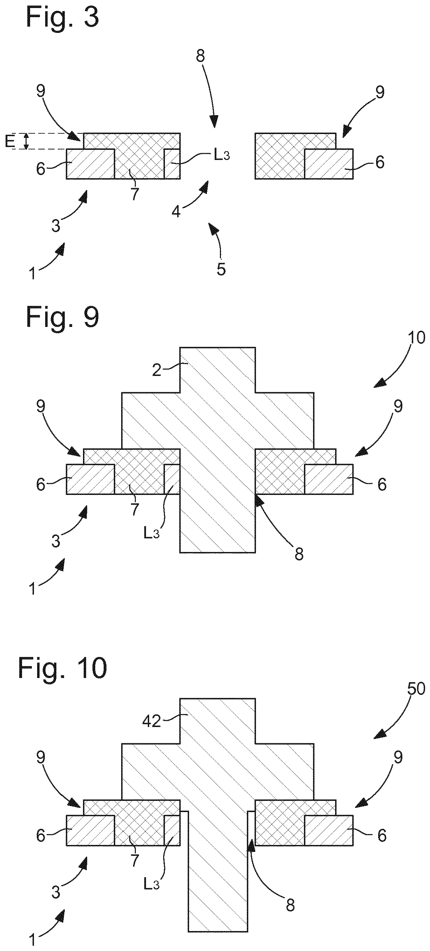

Avantageusement, l'invention se rapporte également à un assortiment 10 comportant un arbre 2 chassé dans le passage 8 d'une pièce composite 1 comme visible à la figure 9. De plus, comme visible à la figure 9, la pièce composite 1 peut être avantageusement bloquée axialement contre une portée de l'arbre 2.

On comprend donc que la pièce composite 1 comporte une force de maintien sur l'arbre qui est améliorée. Ainsi, l'axe 2 chassé dans la pièce composite 1 présente une rigidité bien supérieure à celle de simples structures élastiques 5 du même élément 3 sans surmoulage. De plus, la tenue en couple est fonction de la pression exercée par la matière déformée du passage 8 sur l'axe 2. On comprend donc que cette pression est nettement plus élevée dans le cas de la pièce composite 1.

En outre, le volume 7 en alliage métallique au moins partiellement amorphe permet de protéger l'élément 3 contre les déformations plastiques ce qui autorise l'utilisation d'un matériau « fragile ». Ainsi, la pièce composite 1 peut être chassée, c'est-à-dire emmanchée, sur un arbre 2 métallique avec très peu de risque de bris même si l'élément 3 est par exemple à base de silicium. C'est en effet le volume 7 en alliage métallique au moins partiellement amorphe qui sera éventuellement déformé plastiquement.

De manière additionnelle, même si, accidentellement, l'élément 3 se brisait au niveau d'une des lames L₁, L₂, L₃ des moyens élastiques 5, par exemple, par un choc induit à la pièce d'horlogerie, la tenue serait quand même assurée par le surmoulage. Les parties de l'élément 3 qui se seraient, éventuellement, rompues seraient en effet maintenues en place par le surmoulage, évitant ainsi la libération de celles-ci dans le mouvement de la pièce d'horlogerie.

Enfin, l'utilisation d'un volume en alliage métallique au moins partiellement amorphe permet le démontage de l'assortiment 10. En effet, un alliage métallique au moins partiellement amorphe peut être avantageusement réchauffé à une température prédéterminée comme expliqué ci-dessus qui le rend suffisamment mou pour ne plus opposer de résistance mécanique.

Bien entendu, d'autres modes de réalisation que l'assortiment 10 sont possibles. Ainsi, par exemple, il pourrait être souhaité que les moyens élastiques 5, 15, 25, 35 ne touchent pas à l'axe. Pour répondre à cette problématique, l'arbre et/ou le passage pourrait alors être agencé pour se chasser uniquement contre le volume en alliage métallique au moins partiellement amorphe de la pièce composite.

Un premier mode de réalisation alternatif est illustré à la figure 10. Dans cet exemple, l'assortiment 50 comporte un arbre 42 qui est affiné pour se chasser uniquement contre l'épaisseur E de la partie 9 en saillie du volume 7 en alliage métallique au moins partiellement amorphe de la pièce composite 1. Comme visible à la figure 10, on peut donc voir que le passage 8 de la pièce 1 composite reste non chassé notamment au niveau de la troisième lame L₃ des moyens élastiques 5.

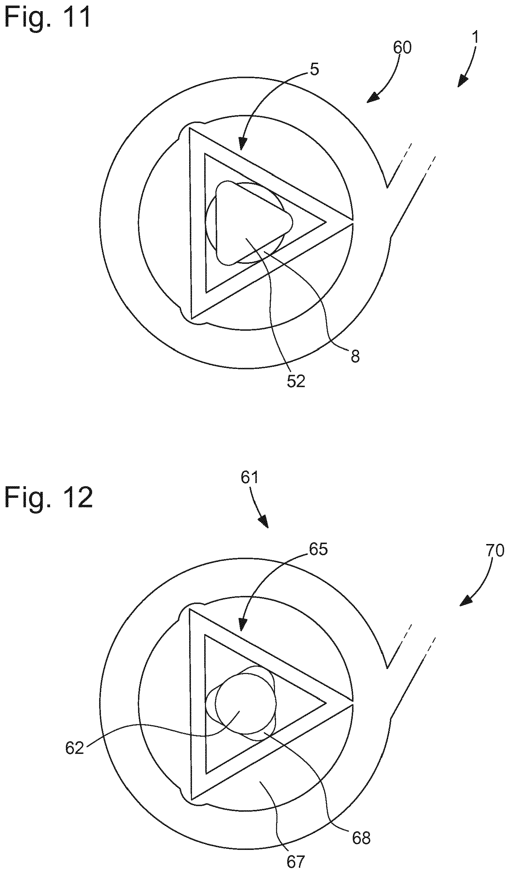

Un deuxième mode de réalisation alternatif est illustré à la figure 11. Dans cet exemple, l'assortiment 60 comporte un arbre 52 comprenant une section de forme différente de celle du passage 8 pour se chasser uniquement contre le volume 7 en alliage métallique au moins partiellement amorphe de la pièce composite 1. Comme visible à la figure 11, on peut donc voir que le passage 8 de la pièce 1 composite reste non chassé notamment au niveau des moyens élastiques 5.

Un troisième mode de réalisation alternatif est illustré à la figure 12. Dans cet exemple, l'assortiment 70 comporte un passage 68 comprenant une section de forme différente de celle de l'arbre 62 pour se chasser uniquement contre le volume 67 en alliage métallique au moins partiellement amorphe de la pièce composite 61. Comme visible à la figure 12, on peut donc voir que le passage 68 de la pièce 61 composite reste non chassé notamment au niveau des moyens élastiques 65.

Bien entendu, la présente invention ne se limite pas à l'exemple illustré mais est susceptible de diverses variantes et modifications qui apparaîtront à l'homme de l'art. En particulier, d'autres types d'éléments (moyens élastiques différents, application différente d'une virole, etc.) ou d'arbre (arbre sans portée, de section différente, etc.) peuvent être mis en œuvre sans sortir du cadre de l'invention.

Un exemple de procédé de fabrication d'une pièce composite 1, 61 va maintenant être expliqué. Selon l'invention, le procédé de fabrication d'une pièce composite comporte une première étape a) destinée à former un élément 3, 13, 23, 33 avec une ouverture 4, 14, 24, 34 dans laquelle s'étendent des moyens élastiques 5, 15, 25, 35, 65.

Le procédé se poursuit avec une étape b) destinée à passer un outil dans l'ouverture 4, 14, 24, 34 de l'élément 3, 13, 23, 33 afin de mettre sous contrainte les moyens élastiques 5, 15, 25, 35, 65. On comprend donc que cet outil formera le futur passage 8, 68.

Le procédé comporte ensuite une étape c) destinée à surmouler l'élément 3, 13, 23, 33 à l'aide d'un alliage métallique au moins partiellement amorphe afin d'emprisonner les moyens élastiques 5, 15, 25, 35, 65 sous contrainte. Pour faciliter cette étape c), un moule peut éventuellement être rapporté sur l'élément 3, 13, 23, 33 pour mieux délimiter la zone de l'élément 3, 13, 23, 33 devant être surmoulée avec l'alliage métallique au moins partiellement amorphe. On comprend notamment que ce moule peut former très précisément la partie 9 en saillie de l'élément 3 offrant une épaisseur E de la pièce composite 1 uniquement réalisée en alliage métallique au moins partiellement amorphe divulgué aux figures 1 à 3.

Enfin le procédé se termine avec l'étape d) destinée à retirer l'outil afin de former la pièce composite 1, 61 munie d'un passage 8, 68 de forme correspondante audit outil.

Bien entendu, la présente invention ne se limite pas à l'exemple illustré mais est susceptible de diverses variantes et modifications qui apparaîtront à l'homme de l'art. En particulier, des moyens d'indexage pourraient être prévus pour parfaitement référencer les organes entre eux.

## Revendications

1. Procédé de fabrication d'une pièce composite (1, 61) comportant les étapes suivantes :
a) former un élément (3, 13, 23, 33) avec une ouverture (4, 14, 24, 34) dans laquelle s'étendent des moyens élastiques (5, 15, 25, 35, 65) ;
b) passer un outil entre les moyens élastiques (5, 15, 25, 35, 65) de l'élément (3, 13, 23, 33) afin de mettre sous contrainte les moyens élastiques (5, 15, 25, 35, 65) ;
c) surmouler l'élément (3, 13, 23, 33) à l'aide d'un alliage métallique au moins partiellement amorphe afin d'emprisonner les moyens élastiques (5, 15, 25, 35, 65) sous contrainte ;
d) retirer l'outil afin de former la pièce composite (1, 61) munie d'un passage (8, 68) de forme correspondante audit outil entre les moyens élastiques (5, 15, 25, 35, 65) sous contrainte.

2. Procédé selon la revendication précédente, **caractérisé en ce que** les moyens élastiques (5, 15, 25, 35, 65) forment au moins deux lames déformables (L₁, L₂, L₃, L'₁, L'₂, L"₁, L"₂) raccordée de manière monobloc avec la paroi de l'ouverture (4, 14, 24, 34) de l'élément (3, 13, 23, 33).

3. Procédé selon la revendication précédente, **caractérisé en ce qu'**au moins une extrémité d'une desdites au moins deux lames déformables (L₁, L₂, L₃, L'₁, L'₂, L"₁, L"₂) est reliée de manière monobloc à au moins une extrémité d'une autre desdites au moins deux lames déformables (L₁, L₂, L₃, L'₁, L'₂, L"₁, L"₂).

4. Procédé selon la revendication précédente, **caractérisé en ce que** lesdites au moins deux lames déformables (L₁, L₂, L₃, L'₁, L'₂, L"₁, L"₂) reliées entre elles forment une structure en forme de V.

5. Procédé selon la revendication 3, **caractérisé en ce que** lesdites au moins deux lames déformables (L₁, L₂, L₃, L'₁, L'2, L"₁, L"₂) reliées entre elles forment un polygone.

6. Procédé selon la revendication 3, **caractérisé en ce que** lesdites au moins deux lames déformables (L₁, L₂, L₃, L'₁, L'₂, L"₁, L"₂) reliées entre elles forment une structure en forme de Y.

7. Procédé selon l'une des revendications précédentes, **caractérisé en ce que**, lors de l'étape c), une ébauche en alliage métallique au moins partiellement amorphe est chauffée entre sa température de transition vitreuse (Tg) et sa température de cristallisation (Tx) afin de surmouler lesdits moyens élastiques.

8. Procédé selon l'une des revendications précédentes, **caractérisé en ce que**, lors de l'étape c), le surmoulage en alliage métallique au moins partiellement amorphe forme une partie (9) en saillie de l'élément (3, 13, 23, 33) afin d'offrir une épaisseur (E) de la pièce composite (1, 61) uniquement réalisée en alliage métallique au moins partiellement amorphe.

9. Procédé selon l'une des revendications précédentes, **caractérisé en ce que**, lors de l'étape c), un moule est rapporté sur l'élément (3, 13, 23, 33) pour délimiter la zone de l'élément (3, 13, 23, 33) pouvant être surmoulée avec l'alliage métallique au moins partiellement amorphe.

10. Pièce composite (1, 61) comportant un élément (3, 13, 23, 33) pourvu d'un volume (7, 67) en alliage métallique au moins partiellement amorphe et de moyens élastiques (5, 15, 25, 35, 65) sous contrainte emprisonnés dans ledit volume (7, 67), ladite pièce composite comportant un passage (8, 68) centré par rapport aux dits moyens élastiques sous contrainte.

11. Pièce composite (1, 61) selon la revendication précédente, **caractérisée en ce que** les moyens élastiques (5, 15, 25, 35, 65) forment au moins deux lames déformables (L₁, L₂, L₃, L'₁, L'₂, L"₁, L"₂) raccordée de manière monobloc avec la paroi de l'ouverture (4, 14, 24, 34) de l'élément (3, 13, 23, 33).

12. Pièce composite (1, 61) selon la revendication précédente, **caractérisée en ce qu'**au moins une extrémité d'une desdites au moins deux lames déformables (L₁, L₂, L₃, L'₁, L'₂, L"₁, L"₂) est reliée de manière monobloc à au moins une extrémité d'une autre desdites au moins deux lames déformables (L₁, L₂, L₃, L'₁, L'₂, L"₁, L"₂).

13. Pièce composite (1, 61) selon la revendication précédente, **caractérisée en ce que** lesdites au moins deux lames déformables (L₁, L₂, L₃, L'₁, L'₂, L"₁, L"₂) reliées entre elles forment une structure en forme de V.

14. Pièce composite (1, 61) selon la revendication 12, **caractérisée en ce que** lesdites au moins deux lames déformables (L₁, L₂, L₃, L'₁, L'₂, L"₁, L"₂) reliées entre elles forment un polygone.

15. Pièce composite (1, 61) selon la revendication 12, **caractérisée en ce que** lesdites au moins deux lames déformables (L₁, L₂, L₃, L'₁, L'₂, L"₁, L"₂) reliées entre elles forment une structure en forme de Y.

16. Pièce composite (1, 61) selon l'une des revendications 10 à 15, **caractérisée en ce que** le volume (7, 67) en alliage métallique au moins partiellement amorphe forme une partie (9) en saillie de l'élément (3, 13, 23, 33) afin d'offrir une épaisseur (E) de la pièce composite (1, 61) uniquement réalisée en alliage métallique au moins partiellement amorphe.

17. Pièce composite (1, 61) selon l'une des revendications 10 à 16, **caractérisée en ce que** l'élément (3, 13, 23, 33) comporte du silicium monocristallin dopé ou non, du silicium polycristallin dopé ou non, de l'oxyde de silicium, du quartz, de la silice, du corindon monocristallin, du corindon polycristallin, de l'alumine, du rubis, du nitrure de silicium ou du carbure de silicium.

18. Pièce composite (1, 61) selon la revendication précédente, **caractérisée en ce que** l'élément (3, 13, 23, 33) comporte au moins un revêtement partiel d'oxyde de silicium, de nitrure de silicium, de carbure de silicium ou d'un allotrope du carbone.

19. Pièce composite (1, 61) selon l'une des revendications 10 à 18, **caractérisée en ce que** le volume (7, 67) en alliage métallique au moins partiellement amorphe est formé à base magnésium, à base titane, à base zirconium, à base fer, à base cobalt, à base or, à base palladium ou à base platine.

20. Pièce composite (1, 61) selon la revendication précédente, **caractérisée en ce que** le volume (7, 67) en alliage métallique au moins partiellement amorphe est formé par un alliage du type ZrTiCuNiBe, PdCuNiP ou PtCuNiP.

21. Assortiment (10, 50, 60, 70) comportant un arbre (2, 42, 52, 62) chassé dans le passage (8, 68) d'une pièce composite (1, 61) selon l'une des revendications 10 à 20.

22. Assortiment (10, 50, 60, 70) selon la revendication précédente, **caractérisé en ce que** l'arbre (2, 42, 52, 62) est agencé pour se chasser uniquement contre le volume (7, 67) en alliage métallique au moins partiellement amorphe de la pièce composite (1, 61).

23. Assortiment (10, 50, 60, 70) selon la revendication 21 ou 22, **caractérisé en ce que** le passage (8, 68) est agencé pour l'arbre (2, 42, 52, 62) se chasse uniquement contre le volume (7, 67) en alliage métallique au moins partiellement amorphe de la pièce composite (1, 61).

24. Assortiment (10, 50, 60, 70) selon l'une des revendications 21 à 23, **caractérisé en ce que** la pièce composite (1, 61) est bloquée contre une portée de l'arbre (2, 42, 52, 62).

25. Assortiment (10, 50, 60, 70) selon l'une des revendications 21 à 24, **caractérisé en ce qu'**il forme tout ou partie d'un rouage (101) d'une pièce d'horlogerie.

26. Assortiment (10, 50, 60, 70) selon l'une des revendications 21 à 24, **caractérisé en ce qu'**il forme tout ou partie d'un système d'échappement (103) d'une pièce d'horlogerie.

27. Assortiment (10, 50, 60, 70) selon l'une des revendications 21 à 24, **caractérisé en ce qu'**il forme tout ou partie d'un résonateur (105) d'une pièce d'horlogerie.

## Patentansprüche

1. Verfahren zur Herstellung eines Bauteils aus einem Verbundwerkstoff (1, 61), umfassend die folgenden Schritte:
a) Ausbilden eines Elements (3, 13, 23, 33) mit einer Öffnung (4, 14, 24, 34), in der sich elastische Mittel (5, 15, 25, 35, 65) ausdehnen;
b) Verbringen eines Werkzeugs zwischen die elastischen Mittel (5, 15, 25, 35, 65) des Elements (3, 13, 23, 33), um die elastischen Mittel (5, 15, 25, 35, 65) unter Spannung zu setzen;
c) Umspritzen des Elements (3, 13, 23, 33) mit Hilfe einer mindestens teilweise amorphen metallischen Legierung, um die elastischen Mittel (5, 15, 25, 35, 65) unter Spannung einzuschließen;
d) Herausnehmen des Werkzeugs, um das Bauteil aus einem Verbundwerkstoff (1, 61) zu bilden, das mit einem Durchgang (8, 68) einer dem Werkzeug entsprechenden Form zwischen den unter Spannung stehenden elastischen Mitteln (5, 15, 25, 35, 65) versehen ist.

2. Verfahren nach dem vorhergehenden Anspruch, **dadurch gekennzeichnet, dass** die elastischen Mittel (5, 15, 25, 35, 65) mindestens zwei verformbare Lamellen (L1, L2, L3, L'1, L'2, L"1, L"2) bilden, die mit der Wand der Öffnung (4, 14, 24, 34) des Elements (3, 13, 23, 33) einstückig verbunden sind.

3. Verfahren nach dem vorhergehenden Anspruch, **dadurch gekennzeichnet, dass** mindestens ein Ende eines der mindestens zwei verformbaren Lamellen (L₁, L₂, L₃, L'₁, L'₂, L"₁, L"₂) einstückig mit mindestens einem Ende eines anderen der mindestens zwei verformbaren Lamellen (L₁, L₂, L₃, L'₁, L'₂, L"₁, L"₂) verbunden ist.

4. Verfahren nach dem vorhergehenden Anspruch, **dadurch gekennzeichnet, dass** die mindestens zwei miteinander verbundenen verformbaren Lamellen (L₁, L₂, L₃, L'₁, L'₂, L"₁, L"₂) eine V-förmige Struktur bilden.

5. Verfahren nach Anspruch 3, **dadurch gekennzeichnet, dass** die mindestens zwei miteinander verbundenen verformbaren Lamellen (L₁, L₂, L₃, L'₁, L'₂, L"₁, L"₂) ein Polygon bilden.

6. Verfahren nach Anspruch 3, **dadurch gekennzeichnet, dass** die mindestens zwei miteinander verbundenen verformbaren Lamellen (L₁, L₂, L₃, L'₁, L'₂, L"₁, L"₂) eine Y-förmige Struktur bilden.

7. Verfahren nach einem der vorhergehenden Ansprüche, **dadurch gekennzeichnet, dass** in Schritt c) ein Rohling aus einer mindestens teilweise amorphen metallischen Legierung auf eine Temperatur zwischen seiner Glasübergangstemperatur (Tg) und seiner Kristallisationstemperatur (Tx) erhitzt wird, um die elastischen Mittel zu umspritzen.

8. Verfahren nach einem der vorhergehenden Ansprüche, **dadurch gekennzeichnet, dass** in Schritt c) das Umspritzen mit einer mindestens teilweise amorphen metallischen Legierung einen vorstehenden Teil (9) des Elements (3, 13, 23, 33) bildet, um dem Bauteil aus einem Verbundwerkstoff (1, 61) eine Dicke (E) zu geben, die ausschließlich aus einer mindestens teilweise amorphen metallischen Legierung gebildet ist.

9. Verfahren nach einem der vorhergehenden Ansprüche, **dadurch gekennzeichnet, dass** in Schritt c) eine Form auf das Element (3, 13, 23, 33) gesetzt wird, um den Bereich des Elements (3, 13, 23, 33), der mit der mindestens teilweisen amorphen metallischen Legierung umspritzt werden kann, zu begrenzen.

10. Bauteil aus einem Verbundwerkstoff (1, 61), umfassend ein Element (3, 13, 23, 33), das mit einem Volumen (7, 67) aus einer mindestens teilweise amorphen metallischen Legierung und mit unter Spannung stehenden elastischen Mitteln (5, 15, 25, 35, 65), die in das Volumen (7, 67) eingeschlossen sind, versehen ist, wobei das Bauteil aus einem Verbundwerkstoff einen Durchgang (8, 68) aufweist, der in Bezug auf die unter Spannung stehenden elastischen Mittel zentriert ist.

11. Bauteil aus einem Verbundwerkstoff (1, 61) nach dem vorhergehenden Anspruch, **dadurch gekennzeichnet, dass** die elastischen Mittel (5, 15, 25, 35, 65) mindestens zwei verformbare Lamellen (L₁, L₂, L₃, L'₁, L'₂, L"₁, L"₂) bilden, die mit der Wand der Öffnung (4, 14, 24, 34) des Elements (3, 13, 23, 33) einstückig verbunden sind.

12. Bauteil aus einem Verbundwerkstoff (1, 61) nach dem vorhergehenden Anspruch, **dadurch gekennzeichnet, dass** mindestens ein Ende eines der beiden verformbaren Lamellen (L₁, L₂, L₃, L'₁, L'₂, L"₁, L"₂) mit mindestens einem Ende eines anderen der mindestens zwei verformbaren Lamellen (L₁, L₂, L₃, L'₁, L'₂, L"₁, L"₂) einstückig verbunden ist.

13. Bauteil aus einem Verbundwerkstoff (1, 61) nach dem vorhergehenden Anspruch, **dadurch gekennzeichnet, dass** die mindestens zwei miteinander verbundenen verformbaren Lamellen (L₁, L₂, L₃, L'₁, L'₂, L"₁, L"₂) eine V-förmige Struktur bilden.

14. Bauteil aus einem Verbundwerkstoff (1, 61) nach Anspruch 12, **dadurch gekennzeichnet, dass** die mindestens zwei miteinander verbundenen verformbaren Lamellen (L₁, L₂, L₃, L'₁, L'₂, L"₁, L"₂) ein Polygon bilden.

15. Bauteil aus einem Verbundwerkstoff (1, 61) nach Anspruch 12, **dadurch gekennzeichnet, dass** die mindestens zwei miteinander verbundenen verformbaren Lamellen (L₁, L₂, L₃, L'₁, L'₂, L"₁, L"₂) eine Y-förmige Struktur bilden.

16. Bauteil aus einem Verbundwerkstoff (1, 61) nach einem der Ansprüche 10 bis 15, **dadurch gekennzeichnet, dass** das Volumen (7, 67) aus einer mindestens teilweise amorphen metallischen Legierung einen von dem Element (3, 13, 23, 33) vorstehenden Teil (9) bildet, um dem Bauteil aus einem Verbundwerkstoffs (1, 61) eine Dicke (E) zu geben, die ausschließlich aus der mindestens teilweise amorphen metallischen Legierung gebildet ist.

17. Bauteil aus einem Verbundwerkstoff (1, 61) nach einem der Ansprüche 10 bis 16, **dadurch gekennzeichnet, dass** das Element (3, 13, 23, 33) dotiertes oder nicht dotiertes einkristallines Silicium, dotiertes oder nicht dotiertes polykristallines Silicium, Siliciumoxid, Quarz, Siliciumdioxid, einkristallinen Korund, polykristallinen Korund, Aluminiumoxid, Rubin, Siliciumnitrid oder Siliciumcarbid enthält.

18. Bauteil aus einem Verbundwerkstoff (1, 61) nach dem vorhergehenden Anspruch, **dadurch gekennzeichnet, dass** das Element (3, 13, 23, 33) mindestens eine Teilbeschichtung aus Siliciumoxid, Siliciumnitrid, Siliciumcarbid oder einem Kohlenstoffallotrop aufweist.

19. Bauteil aus einem Verbundwerkstoff (1, 61) nach einem der Ansprüche 10 bis 18, **dadurch gekennzeichnet, dass** das Volumen (7, 67) der mindestens teilweise amorphen metallischen Legierung auf Magnesiumbasis, Titanbasis, Zirkoniumbasis, Eisenbasis, Kobaltbasis, Goldbasis, Palladiumbasis oder Platinbasis gebildet ist.

20. Bauteil aus einem Verbundwerkstoff (1, 61) nach dem vorhergehenden Anspruch, **dadurch gekennzeichnet, dass** das Volumen (7, 67) der mindestens teilweise amorphen metallischen Legierung aus einer Legierung vom Typ ZrTiCuNiBe, PdCuNiP oder PtCuNiP gebildet ist.

21. Zusammenstellung (10, 50, 60, 70), umfassend eine Welle (2, 42, 52, 62), die in den Durchlass (8, 68) eines Bauteils aus einem Verbundwerkstoff (1, 61) nach einem der Ansprüche 10 bis 20 eingepresst ist.

22. Zusammenstellung (10, 50, 60, 70) nach dem vorhergehenden Anspruch, **dadurch gekennzeichnet, dass** die Welle (2, 42, 52, 62) so angeordnet ist, dass sie ausschließlich gegen das Volumen (7, 67) einer mindestens teilweise amorphen metallischen Legierung des Bauteils aus einem Verbundwerkstoff (1, 61) eingepresst wird.

23. Zusammenstellung (10, 50, 60, 70) nach Anspruch 21 oder 22, **dadurch gekennzeichnet, dass** der Durchlass (8, 68) dazu vorgesehen ist, dass die Welle (2, 42, 52, 62) ausschließlich gegen das Volumen (7, 67) einer mindestens teilweise amorphen metallischen Legierung des Bauteils aus einem Verbundwerkstoff (1, 61) eingepresst wird.

24. Zusammenstellung (10, 50, 60, 70) nach einem der Ansprüche 21 bis 23, **dadurch gekennzeichnet, dass** das Bauteil aus einem Verbundwerkstoff (1, 61) gegenüber einem Umfang der Welle (2, 42, 52, 62) blockiert ist.

25. Zusammenstellung (10, 50, 60, 70) nach einem der Ansprüche 21 bis 24, **dadurch gekennzeichnet, dass** sie ein gesamtes Räderwerk (101) einer Uhr oder einen Teil hiervon bildet.

26. Zusammenstellung (10, 50, 60, 70) nach einem der Ansprüche 21 bis 24, **dadurch gekennzeichnet, dass** sie ein gesamtes Hemmungssystem (103) einer Uhr oder einen Teil hiervon bildet.

27. Zusammenstellung (10, 50, 60, 70) nach einem der Ansprüche 21 bis 24, **dadurch gekennzeichnet, dass** sie einen gesamten Resonator (105) einer Uhr oder einen Teil hiervon bildet.

## Claims

1. Method for fabrication of a composite component (1, 61) comprising the following steps:
a) forming an element (3, 13, 23, 33) with an opening (4, 14, 24, 34) into which resilient means (5, 15, 25, 35, 65) extend;
b) placing a tool between the resilient means (5, 15, 25, 35, 65) of the element (3, 13, 23, 33) so as to place the resilient means (5, 15, 25, 35, 65) under stress;
c) overmoulding the element (3, 13, 23, 33) with an at least partially amorphous metal alloy so as to confine the resilient means (5, 15, 25, 35, 65) under stress;
d) removing the tool to form the composite component (1, 61) provided with a passage (8, 68) of corresponding shape to the tool between the resilient means (5, 15, 25, 35, 65) under stress.

2. Method according to claim 1, **characterized in that** the resilient means (5, 15, 25, 35, 65) form at least two deformable strips (L₁, L₂, L₃, L'₁, L'₂, L"₁, L"₂) connected in one-piece to the wall of the opening (4, 14, 24, 34) in the element (3, 13, 23, 33).

3. Method according to claim 2, **characterized in that** at least one end of one of the at least two deformable strips (L₁, L₂, L₃, L'₁, L'₂, L"₁, L"₂) is connected in one-piece to at least one end of another of the at least two deformable strips (L₁, L₂, L₃, L'₁, L'₂, L"₁, L"₂).

4. Method according to claim 3, **characterized in that** the at least two interconnected deformable strips (L₁, L₂, L₃, L'₁, L'₂, L"₁, L"₂) form a V-shaped structure.

5. Method according to claim 3, **characterized in that** the at least two interconnected deformable strips (L₁, L₂, L₃, L'₁, L'₂, L"₁, L"₂) form a polygon.

6. Method according to claim 3, **characterized in that** the at least two interconnected deformable strips (L₁, L₂, L₃, L'₁, L'₂, L"₁, L"₂) form a Y-shaped structure.

7. Method according to any of claims 1 to 6, **characterized in that**, in step c), an at least partially amorphous metal alloy blank is heated between its glass transition temperature (Tg) and its crystallization temperature (Tx) in order to overmould the resilient means.

8. Method according to any of claims 1 to 7, **characterized in that**, in step c), the at least partially amorphous metal alloy overmould forms a protruding portion (9) of the element (3, 13, 23, 33) so as to provide a thickness (E) of the composite component (1, 61) formed entirely of at least partially amorphous metal alloy.

9. Method according to any of claims 1 to 8, **characterized in that**, in step c), a mould is placed on the element (3, 13, 23, 33) to delimit the area of the element (3, 13, 23, 33) that can be overmoulded with the at least partially amorphous metal alloy.

10. Composite component (1, 61) comprising an element (3, 13, 23, 33) with a volume (7, 67) of at least partially amorphous metal alloy and stressed resilient means (5, 15, 25, 35, 65) confined within said volume (7, 67), the said composite component comprising a passage (8, 68) that is centred with respect to the stressed resilient means.

11. Composite component (1, 61) according to claim 10, **characterized in that** the resilient means (5, 15, 25, 35, 65) form at least two deformable strips (L₁, L₂, L₃, L'₁, L'₂, L"₁, L"₂) connected in one-piece to the wall of the opening (4, 14, 24, 34) in the element (3, 13, 23, 33).

12. Composite component (1, 61) according to claim 11, **characterized in that** at least one end of one of the at least two deformable strips (L₁, L₂, L₃, L'₁, L'₂, L"₁, L"₂) is connected in one-piece to at least one end of another of the at least two deformable strips (L₁, L₂, L₃, L'₁, L'₂, L"₁, L"₂).

13. Composite component (1, 61) according to claim 12, **characterized in that** the at least two interconnected deformable strips (L₁, L₂, L₃, L'₁, L'₂, L"₁, L"₂) form a V-shaped structure.

14. Composite component (1, 61) according to claim 12, **characterized in that** the at least two interconnected deformable strips (L₁, L₂, L₃, L'₁, L'₂, L"₁, L"₂) form a polygon.

15. Composite component (1, 61) according to claim 12, **characterized in that** the at least two interconnected deformable strips (L₁, L₂, L₃, L'₁, L'₂, L"₁, L"₂) form a Y-shaped structure.

16. Composite component (1, 61) according to any of claims 10 to 15, **characterized in that** the volume (7, 67) of at least partially amorphous metal alloy forms a protruding portion (9) of the element (3, 13, 23, 33) so as to provide a thickness (E) of the composite component (1, 61) formed entirely of at least partially amorphous metal alloy.

17. Composite component (1, 61) according to any of claims 10 to 16, **characterized in that** the element (3, 13, 23, 33) includes doped or undoped single crystal silicon, doped or undoped polycrystalline silicon, silicon oxide, quartz, silica, single crystal corundum, polycrystalline corundum, alumina, ruby, silicon nitride or silicon carbide.

18. Composite component (1, 61) according to claim 17, **characterized in that** the element (3, 13, 23, 33) includes at least a partial coating of silicon oxide, silicon nitride, silicon carbide or an allotrope of carbon.

19. Composite component (1, 61) according to any of claims 10 to 18, **characterized in that** the volume (7, 67) of at least partially amorphous metal alloy is formed of a magnesium-based, titanium-based, zirconium-based, iron-based, cobalt-based, gold-based, palladium-based or platinum-based alloy.

20. Composite component (1, 61) according to claim 19, **characterized in that** the volume (7, 67) of at least partially amorphous metal alloy is formed by an alloy of the ZrTiCuNiBe, PdCuNiP or PtCuNiP type.

21. Assortment (10, 50, 60, 70) comprising an arbor (2, 42, 52, 62) driven into the passage (8, 68) of a composite component (1, 61) according to any of claims 10 to 20.

22. Assortment (10, 50, 60, 70) according to claim 21, **characterized in that** the arbor (2, 42, 52, 62) is arranged only to be pressed against the volume (7, 67) of at least partially amorphous metal alloy of the composite component (1, 61).

23. Assortment (10, 50, 60, 70) according to claim 21 or 22, **characterized in that** the passage (8, 68) is arranged so that the arbor (2, 42, 52, 62) is only pressed against the volume (7, 67) of at least partially amorphous metal alloy of the composite component (1, 61).

24. Assortment (10, 50, 60, 70) according to any of claims 21 to 23, **characterized in that** the composite component (1, 61) is locked against a shoulder of the arbor (2, 42, 52, 62).

25. Assortment (10, 50, 60, 70) according to any of claims 21 to 24, **characterized in that** the assortment forms all or part of a gear train (101) of a timepiece.

26. Assortment (10, 50, 60, 70) according to any of claims 21 to 24, **characterized in that** the assortment forms all or part of an escapement system (103) of a timepiece.

27. Assortment (10, 50, 60, 70) according to any of claims 21 to 24, **characterized in that** the assortment forms all or part of a resonator (105).
